# EUROPEAN PATENT SPECIFICATION

(11) **EP 0 282 279 B1**
(45) Date of publication and mention of the grant of the patent: **18.11.1993**
(21) Application number: 88302040.6
(22) Date of filing: 09.03.1988
(51) Int. Cl.: H04N 5/14, G11C 27/04, G11C 19/28

(54) **Apparatus for compressing and/or expanding time base**
Vorrichtung zur Kompression und/oder Dehnung einer Zeitbasis
Dispositif de compression et/ou d'expansion d'une base de temps

(30) Priority: 12.03.1987 JP 57818/87
(43) Date of publication of application: 14.09.1988
(73) Proprietor: SONY CORPORATION, Tokyo 141 (JP)
(72) Inventor: Urata, Kaoru, Shinagawa-ku Tokyo (JP); Nakashio, Miaki, Shinagawa-ku Tokyo (JP); Ono, Koichi, Shinagawa-ku Tokyo (JP); Hirai, Hitoshi, Shinagawa-ku Tokyo (JP); Iwamoto, Masayuki, Shinagawa-ku Tokyo (JP)
(74) Representative: Ayers, Martyn Lewis Stanley

(56) References cited:
- PATENT ABSTRACTS OF JAPAN, vol. 9, no. 295 (E-360)[2018], 21st November 1985; & JP-A-60 134 682 (MATSUSHITA DENKI SANGYO K.K.) 17-07-1985
- PROCEEDINGS OF THE 2ND INTERNATIONAL CONFERENCE ON CHARGE COUPLED DEVICES, Edinburgh, 1975, pages 389-398; Y.T. CHAN et al.: "Extremely high speed CCD analog delay line"
- PROCEEDINGS OF 5TH INTERNATIONAL CONFERENCE ON CHARGE-COUPLED DEVICES, September 1979, pages 328-333, Edinburgh, GB; J.C. WHITE et al.: "A CCD bandwidth compressor for airborne radar applications"
- IBM TECHNICAL DISCLORURE, vol. 15, no. 2, July 1972, pages 472-475, New York, US; C.F. JOHNSON: "Bucket-brigade circuits"

## Description

This invention generally relates to an apparatus for compressing and/or expanding the time base of a signal and, more particularly, is directed to such an apparatus using a charge coupled device (hereinafter CCD).

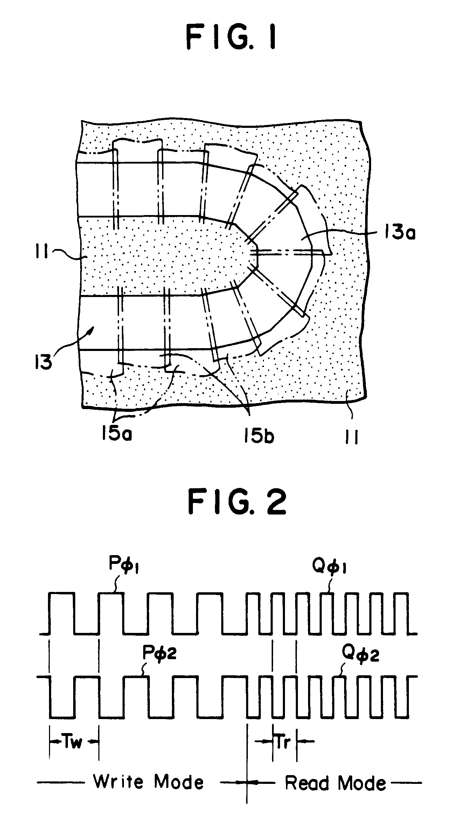

There is known art using a CCD for compressing or expanding the time base of an information signal such as a video signal. The CCD used in such an apparatus is a semiconductor chip on which is formed a charge transfer channel surrounded by channel stop regions; the charge transfer channel is provided with, for example, transfer electrodes of two-phase type disposed thereon, and the CCD is driven with a two-phase transfer clock pulse signal applied to the transfer electrodes. Usually, the desired length of the charge transfer channel is achieved by effectively utilising the space on the semiconductor chip. To do this, the charge transfer channel is arranged to have bend portions as shown in fig 1. In the case as shown in fig 1, the charge transfer channel 13 surrounded by channel stop regions 11 has a bend portion 13a and the direction of transfer of the electric charges is reversed at the bend portion 13a. On the charge transfer channel 13, there are disposed transfer electrodes 15a and 15b of two-phase type alternating in the direction along the charge transfer channel 13.

When compression or expansion of the time base of a video signal is performed using such a CCD, the CCD is driven by a transfer clock pulse signal at a predetermined frequency for writing, whereby the video signal is written to the CCD. In succession thereto, the CCD is driven by a transfer clock pulse signal of a different frequency so as to read the video signal out of the CCD at a different rate. For example, when time base compression is performed, first in the write mode period, a video signal is supplied to the CCD, and at the same time, the transfer electrodes 15a and 15b disposed on the charge transfer channel 13 are supplied with pulse train signals Pφ1 and Pφ2, as the two-phase transfer clock pulse signal for writing, respectively, which have a duty cycle of 50% and a period of Tw and are 180° out of phase with each other as shown in fig 2. Thereby, the CCD is driven and the signal charges based upon the video signal are transferred through the charge transfer channel 13 and, as a result, a predetermined portion of the video signal for, for example, one horizontal line, is written into the charge transfer channel 13.

Then, in the read mode period following the write mode, the transfer electrodes 15a and 15b disposed on the charge transfer channel 13 are supplied with pulse train signals Qφ1 and Qφ2, as the two-phase transfer clock pulse signal for reading, respectively, which have a duty cycle of 50% and a period of Tr corresponding, for example, to a half of the period Tw and are 180° out of phase with each other as shown in fig 2. Thereby, the CCD is driven and the signal charges based upon the video signal written in the charge transfer channel 13 is transferred therethrough, and as a result, a video signal corresponding to one horizontal line is read out of the charge transfer channel 13. Thus, the video single written in the CCD with the two-phase transfer clock pulse signal for writing have a period Tw is read out from the CCD with the two-phase transfer clock pulse signal for reading have a period Tr corresponding to Tw/2, and thereby, the video signal read out from the CCD has its time base compressed to a half of that of the original video signal.

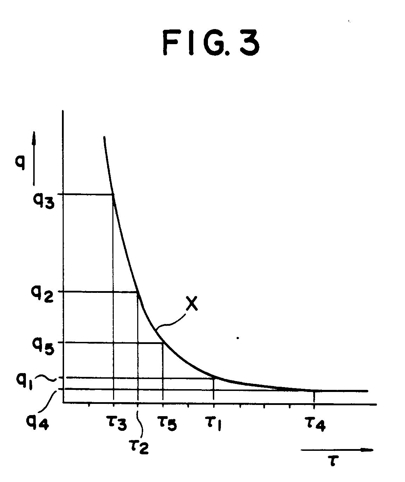

As described in the foregoing, the charge transfer channel of the CCD used, for example, for compressing the time base of a video signal has bend portions as shown in fig 1, and it is considered that there are energy "defects" in such bend portions, and therefore, when charges are transferred therethrough, some charges remain untransferred in such a defect". The quantity of the remaining, or residual, charges in the "defect" varies according to the pulse width of the transfer clock pulse signal at the time of the charge transferring operation. For example, as shown by a curve X in fig 3 indicating the relationship between the quantity of the residual charge q in such a "defect" and the pulse width τ of the transfer clock pulse signal, the smaller the pulse width τ is, the large becomes the quantity of the residual charge q.

Such residual charges produced in the bend portion of the charge transfer channel at the time of charge transfer operation through the charge transfer channel of the CCD does not cause any noise component in the output signal from the CCD as long as their quantity is kept constant, but if the quantity varies, that is, if the pulse width of the transfer clock pulse signal varies, it causes changes in the quantity of the transferred signal charges, and as a result, noise components are produced in the output signal from the CCD.

Under these circumstances, when, for example, the time base compression of a video signal is performed as described above, the transfer clock pulse signal changes from the two-phase transfer clock pulse signal for writing to the two-phase transfer clock pulse signal for reading between the write mode period and the succeeding read mode period, and therefore, the period of the transfer clock pulse signal changes from Tw to Tr, which corresponds to a half of Tw, and the pulse width also changes from Tw/2 to Tr/2. Hence, at the beginning of the read mode period, there occurs a change in the residual charge quantity produced in the bend portion, which affects the time-base-compressed video signal read out of the CCD, so that a noise component is produced therein. More particularly, the video signal output from the CCD tends to include a noise component at the portion corresponding to the signal charge transferred through the bend portion of the charge transfer channel at the beginning of the read mode period. Besides, since the positions of the bend portions are fixed and correspond to certain timings in the horizontal period, the noises take on a fixed pattern and become very conspicuous.

In view of the aforementioned disadvantages in the prior art, the present invention has as its object the provision of a time base compressing and/or expanding apparatus, which, using a CCD having its charge transfer channel provided with bend portions therein, functions to compress or expand the time base of an input signal supplied to the CCD and provide the same at the output side of the CCD, and further, is capable of effectively reducing the noise components liable to be included in the signal obtained from the output side of the CCD due to the charge transfer operation through the bend portions in the charge transfer channel of the CCD.

According to the present invention, there is provided apparatus for compressing and/or expanding the time base of an input signal, characterised in that it comprises:
charge coupled device means having an input terminal which in use is supplied with said input signal, an output terminal, first and second clock terminals, and a charge transfer channel through which charges corresponding to said input signal are transferred, said charge transfer channel having bend portions at which the direction of the charge transfer is changed,
clock generating means for generating a write clock signal and a read clock signal in a time-divisional manner, the frequency of said read clock signal being different from that of said write clock signal, and
clock driver means selectively supplied with one of said write and read clock signals for generating first and second pulse trains to be supplied to said first and second clock terminals, respectively, when said write clock signal is supplied and generating third and fourth pulse trains to be supplied to said first and second terminals, respectively, when said read clock signal is supplied, said first pulse train being 180° out of phase with said second pulse train and said third pulse train being 180° out of phase with said fourth pulse train the pulse width of said first pulse train being substantially equal to that of said third pulse train and being smaller than half of the shorter one of said write clock period and read clock period

When time base compression or expansion of an input signal is carried out in the time base compressing and/or expanding apparatus according to the present invention constructed as described above, writing the input signal to the CCD is performed by transferring operations of signal charges through the charge transfer channel of the CCD according to the first two-phase transfer clock pulse signal made up of the first and second pulse train signals and, in succession thereto, reading out of the CCD the signal obtained from the input signal with its time base compressed or expanded is performed by transferring operations of signal charges through the charge transfer channel of the CCD according to the second two-phase transfer clock pulse signal made up of the third and fourth pulse train signals.

The invention will be further described by way of non-limitative example with reference to the accompanying drawings, in which:-
Fig 1 is a drawing used for explaining a bend portion of a charge transfer channel in a CCD;
Fig 2 is a waveform chart showing an example of a two-phase transfer clock pulse signal for the CCD;
Fig 3 is a graph for describing residual charges in the bend portion of the charge transfer channel of the CCD;
Fig 4 is a block diagram showing an example of a time base compressing and/or expanding apparatus according to the present invention;
Figs 5A to 5D are waveform charts used for explaining operations in the example of fig 4;
Fig 6 is a circuit diagram showing the structure of the clock driver 25 of fig 4;
Fig 7 is a waveform chart for explaining the operations in the circuit diagram of fig 6;
Fig 8 is a block diagram showing a colour-difference signal compressing apparatus to which the present invention is applied;
Fig 9 is a chart for explaining operations in the block diagram of fig 8;
Fig 10 is a block diagram showing a colour-difference signal expanding apparatus to which the present invention is applied; and
Fig 11 is a chart for explaining operations in the block diagram of fig 10.

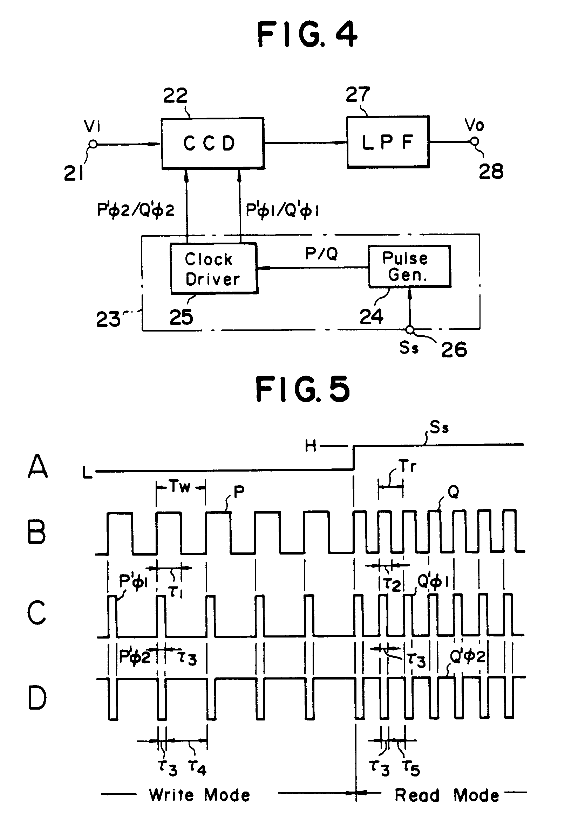

Fig 4 shows an example of a time base compressing and/or expanding apparatus according to the present invention and this example is that adapted for compressing the time base of a video signal.

Referring to fig 4, an input video signal Vi from an input terminal 21 is supplied to the input terminal of a CCD 22. The CCD 22 is a semiconductor chip in which a charge transfer channel is formed surrounded by channel stop regions. So that the space on the semiconductor chip may be effectively utilised the charge transfer channel is arranged to have bend portions as indicated in the charge transfer channel 13 of fig 1. Such a CCD 22 is provided with two-phase type transfer electrodes disposed on the charge transfer channel and adapted to be driven by two-phase transfer clock pulses applied to the transfer electrodes. Driven by the two-phase transfer clock pulses, the CCD performs writing of the video signal Vi input from the input terminal 21 and reading of the written video signal Vi.

In association with such a CCD 22, there is provided a driver circuit portion 23 consisting of a pulse generator 24 and a clock driver 25 for forming two-phase transfer clock pulse signals to be supplied to CCD 22, the signals corresponding to each of the write mode in which the video signal Vi from the input terminal 21 is written to the CCD 22 and the read mode in which the written video signal Vi is read out from the CCD 22. The pulse generator 24 is supplied with a mode selector signal Ss from a terminal 26.

The output terminal of the CCD 22 is connected through a low-pass filter (LPF) 27 to an output terminal 28.

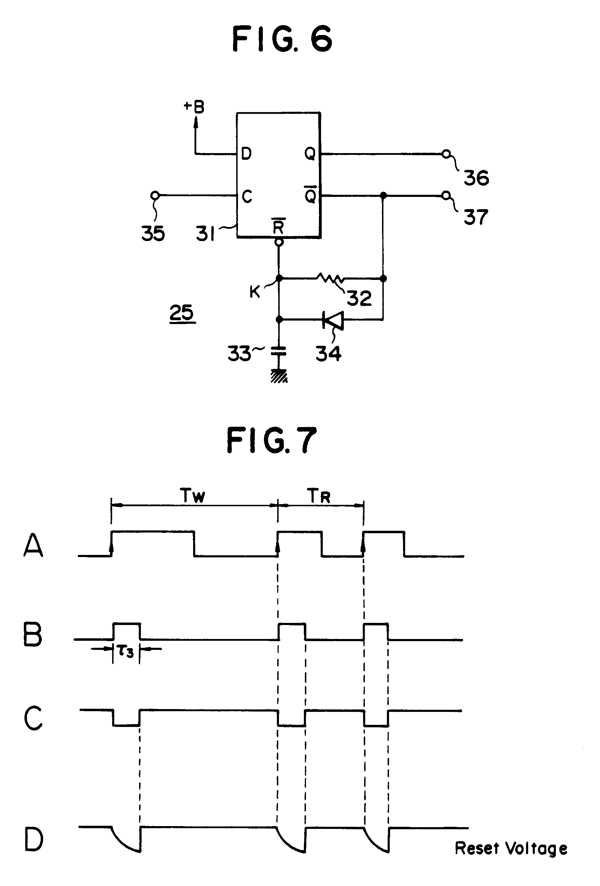

Firstly, as the video signal Vi from the input terminal 21 is supplied to the input terminal of the CCD 22, the write mode is established, and in the write mode, the mode selector signal Ss from the terminal 26 is made to take the low level L as shown in fig 5A. Thereby, the pulse generator 24 generates a pulse train signal P formed of successive pulses having a period Tw and a pulse width $\text{τ1 (= 1/2 Tw)}$ as shown in fig 5B and supplies the pulse train signal P to the clock driver 25. The clock driver 25, responding to the pulse train signal P generates, as shown in figs 5C and 5D, a pulse train signal Pʹφ1 formed of successive pulses having a period Tw and a pulse width τ3 smaller than τ1/2 and a pulse train signal Pʹφ2 formed of successive pulses having a period Tw and a pulse width τ4 larger than τ1 and arranged to be 180° out of phase with the pulse train signal Pʹφ1, and supplies these pulse train signals Pʹφ1 and Pʹφ2 to the CCD 22 as the two-phase transfer clock pulse signal for writing. Thereupon, the CCD 22 is driven by the pulse train signals Pʹφ1 and Pʹφ2, whereby the transfer of signal charges based upon the video signal Vi is performed through the charge transfer channel of the CCD 22 and the video signal Vi for a predetermined portion, for one horizontal period, for example, is written into the charge transfer channel of the CCD 22.

Next, during the read mode period succeeding the write mode period, the mode selector signal Ss from the terminal 26 is made to take the high level H as shown in fig 5A. Thereby, the pulse generator 24 generates a pulse train signal Q formed of successive pulses having a period Tr corresponding, for example, to Tw/2 and a pulse width $\text{τ2 (= 1/2 Tr)}$ 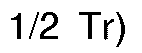 as shown in fig 5B and supplies the pulse train signal Q to the clock driver 25. The clock driver 25 responding to the pulse train signal Q generates, as shown in figs 5C and 5D, a pulse train signal Qʹφ1 formed of successive pulses having a period Tr and a pulse width τ3 smaller than $\text{τ2 (= 1/2 Tr)}$ and a pulse train signal Qʹφ2 formed of successive pulses having a period Tr and a pulse width τ5 larger than τ2 and arranged to be 180° out of phase with the pulse train signal Qʹφ1 and supplies these pulse train signals Qʹφ1 and Qʹφ2 to the CCD 22 as the two-phase transfer clock pulse signal for reading. Thereupon, the CCD 22 is driven by the pulse train signals Qʹφ1 and Qʹφ2, whereby the transfer of signal charges through the charge transfer channel of the CCD 22 based upon the video signal Vi written therein is performed and the video signal Vi for one horizontal period is read out. In the described way, by having the video signal Vi written to the CCD 22 driven by the two-phase transfer clock pulse writing signal consisting of the pulse train signals Pʹφ1 and Pʹφ2 whose period is Tw and then having the signal read out from the CCD 22 driven by the two-phase transfer clock pulse reading signal consisting of the pulse train signals Qʹφ1 and Qʹφ2 whose period is Tr corresponding to Tw/2, the video signal read out of the CCD 22 has its time base compressed to a half of that of the original video signal Vi.

The video signal thus read out of the CCD 22 is delivered through the low-pass filter 27, wherein its clock pulse signal component is removed, to the output terminal 28, and thereby, a video signal Vo whose time base has been compressed can be obtained from the output terminal 28.

The aforementioned pulse widths τ1 to τ5, obey the relationship τ3 < τ2 < τ5 < τ1 < τ4. Supposing tha transfers through the charge transfer channel of a CCD 22 are performed by the transfer clock pulse signals each thereof having the pulse width τ1 - τ5, the quantities of the residual charges at the energy "defect" at the bend portion of the charge transfer channel of the CCD 22 will become q1, q2, q3, q4 and q5 corresponding to the pulse widths τ1 - τ5, respectively, as indicated in fig 3 relative to the curve X, and it is thereby known that there is the relationship q3 > q2 > q5 > q1 > q4 among these charge quantities q1 - q5.

Under these circumstances, when a compression of the time base of a video signal Vi is carried out as described above, the signal transfer through the charge transfer channel of the CCD 22 during the write mode period is performed by the pulse train signal formed of pulses having the pulse width τ3 as the clock pulse signal of one phase of the two-phase transfer clock pulse signal and by the pulse train signal P'φ2 formed of pulses having the pulse width τ4 as the clock pulse signal of the other phase of the two-phase transfer clock pulse signal, and that during the read mode period following the write mode period is performed by the pulse train signal Qʹφ1 formed of pulses having the pulse width τ3 as the clock pulse signal of one phase of the two-phase transfer clock pulse signal and by the pulse train signal Qʹφ2 formed of pulses having the pulse width τ5 as the clock pulse signal of the other phase of the two-phase transfer clock pulse signal. Therefore, at the moment of switching from the write mode to the read mode, the period of the clock pulse signal of the one phase of the two-phase transfer clock pulse signal causing the signal charges to transfer through the transfer channel of the CCD 22 changes from Tw to Tr but the pulse width thereof is kept unchanged to be τ3, whereas the period of the clock pulse signal of the other phase of the two-phase transfer clock pulse signal changes from Tw to Tr and the pulse width thereof changes from τ4 to τ5.

Consequently, the residual charge quantity q3 corresponding to the pulse width τ3 and the residual charge quantity q4 corresponding to the pulse width τ4 are produced at the bend portion of the charge transfer channel of the CCD 22 in the write mode, and the residual charge quantity q3 corresponding to the pulse width τ3 and the residual charge quantity q5 corresponding to the pulse width τ5 are produced in the read mode, and therefore, the change from the residual charge quantity q4 to the residual charge quantity q5 only is produced as the change in the residual charge quantity at the bend portion of the charge transfer channel of the CCD 22 accompanying the switching from the write mode to the read mode. That is, when the write mode is switched to the read mode, the change in the residual charge quantity at the bend portion of the charge transfer channel of the CCD 22 is not produced by the clock pulse signals of the one phase of the two-phase transfer clock pulse signals, but produced only by the clock pulse signals of the other phase of the two-phase transfer clock pulse signals as the change from the residual charge quantity q4 to the residual charge quantity q5 due to the change from the pulse width τ4 to the pulse width τ5.

As described above, by making the pulse width τ3 smaller than a half of the pulse width τ1, and also, the pulse width τ5 is made larger than the pulse width τ2, and therefore, both the residual charge quantity q4 and the residual charge quantity q5 are made relatively small, and further, the difference between the residual charge quantity q4 and the residual charge quantity q5, (q5 - q4), is made relatively small. Thus, the change in the residual charge quantity from the residual charge quantity q4 to the residual charge quantity q5 is kept relatively small.

Accordingly, the noise components included in the output signal Vo due to the change in the residual charge quantity at the bend portion of the charge transfer channel of the CCD 22 are effectively reduced.

Further, since the pulse train signals Pʹφ1 and Qʹφ1 as the clock pulse signals of the one phase of the two-phase transfer clock pulse signals during the write mode period and the succeeding read mode period are made of pulses having the common pulse width τ3, the level of the video signal Vo, of which the time base has been compressed, obtained from the output side of the CCD 22 and through the low-pass filter 27 at the output terminal 28 is kept at a stabilised level.

Although it is stated in the above described example that the period of the two-phase transfer clock pulse signal for reading which is supplied to the CCD 22 during the read mode is made smaller than the period of the two-phase transfer clock pulse signal for writing which is supplied to the CCD 22 during the write mode, and compression of the time base of the signal is thereby performed in the CCD 22, the apparatus according to the present invention can also be used for expansion of the time base of the signal in the CCD 22 by making the period of the two-phase transfer clock pulse signal for reading to be supplied to the CCD 22 during the read mode larger than the period of the two-phase transfer clock pulse signal for writing to be supplied to the CCD 22 during the write mode. In such a case, the pulse width and used as the clock pulse signals of the one phase of the two-phase transfer clock pulse signals during the write mode period and the read mode period in succession thereto are selected to be such that the common pulse width is smaller than the pulse width of the pulse train signal supplied from the pulse generator 24 during the write mode period.

Now, the construction and operation of the clock driver 25 of fig 4 will be described with reference to figs 6 and 7. As described above, the transfer pulse width τ3 of the transfer clock pulse signal corresponds to a very short period of time (for example, tens of a nano-second), and therefore, in order to generate such a transfer clock pulse signal of a constant pulse width, it becomes necessary to use, for example, a high speed device such as ECL as the monostable multivibrator for generating the pulse signal. However, if such a device is used, the power consumption becomes large and the circuit itself might become large and expensive. Therefore, an example of a clock driver free from such disadvantages is shown in fig 6. Referring to fig 6, 31 denotes a D flip-flop formed, for example, of high speed C-MOS gates. The input terminal D of the D flip-flop 31 is connected to a power supply terminal +B, the inverting output terminal Q of the D flip-flop 31 is grounded through a series circuit of a resistor 32 and a capacitor 33, the junction point K of the resistor 32 and the capacitor 33 is connected with the reset terminal R of the D flip-flop 31, and the resistor 32 is shunted by a diode 34. The input terminal 35 to be supplied with input pulse signals, ie, the pulse train signals P, Q in the present example, is connected with the clock terminal C of the D flip-flop 31 and the output terminals 36 and 37 are lead out from the non-inverting output terminal Q and the inverting output terminal Q of the same.

In the example of fig 6, at the timing of the leading edge of the pulse signal supplied to the input terminal 35, the signal obtained at the inverting output terminal Q of the D flip-flop 31 goes from high level "1" to low level "0". As a result, the charge stored on the capacitor 33 during the period at high level "1" is gradually discharged through the resistor 32 until, after a predetermined period of time, the voltage at the junction point K drops to the reset voltage whereby the D flip-flop 31 is reset. In this case, the predetermined period of time can be adjusted by changing the values of the resistor 32 and the capacitor 33, and it is set, as described below, to τ3 in the present example. When the D flip-flop 31 is reset, the signal obtained from its inverting output terminal Q goes from low level "0" to high level "1", and thereupon, the capacitor 33 is quickly charged through the diode 34. Therefore, when a pulse signal as shown in fig 7A is supplied to the example of fig 6, there appear pulse signals as shown in figs 7B and 7C at the output terminals 36 and 37. These pulses apparently correspond to the pulses shown in figs 5C and 5D. Fig 7D shows variations in voltage at the junction point K.

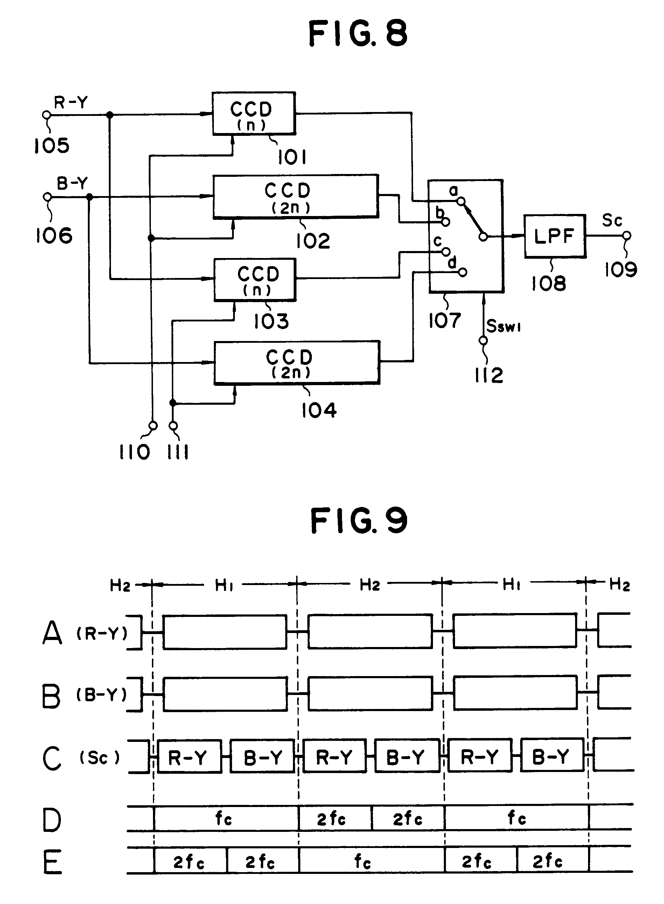

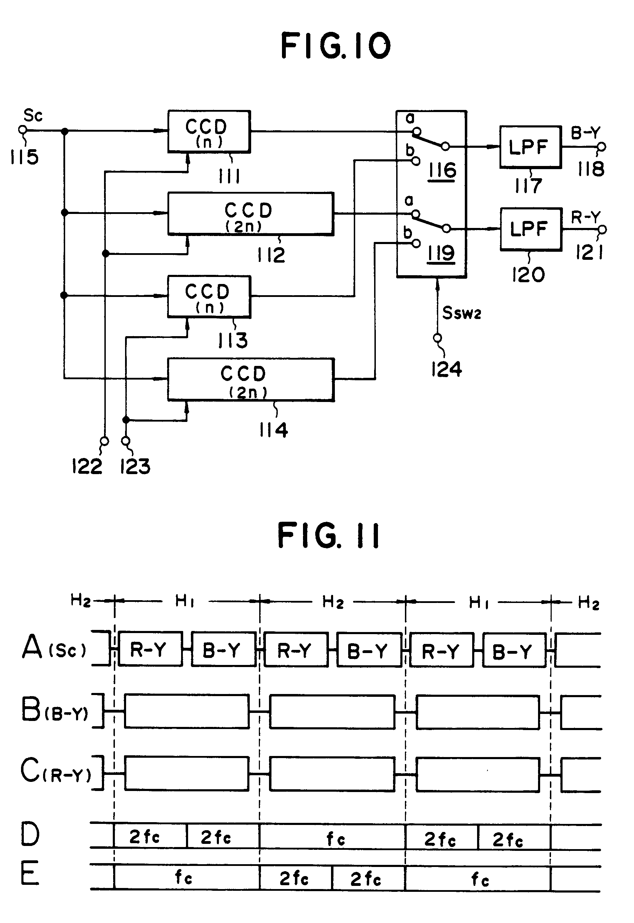

Now, examples of time base compressing and expanding apparatus according to the present invention applied to compressing and expanding of colour-difference signals R-Y, B-Y will be described with reference to figs 8 and 10.

Referring to fig 8, 101 and 103 denote CCDs each thereof having a number of bits (stages) for one horizontal period (n bits). 102 and 104 denote CCDs each thereof having a number of bits for two horizontal periods (2n bits). The CCDs 101, 103 are supplied with the red colour-difference signal R-Y (as shown in fig 9A) from a terminal 105, and the CCDs 102, 104 are supplied with the blue-colour difference signal B-Y (as shown in fig 9B) from another terminal 106. Output signals of the CCDs 101-104 are respectively, supplied to terminals a-d of a switch circuit 107 and the output signal of the switch circuit 107 is applied to an output terminal 109 via a low-pass filter 108.

During two successive horizontal periods H₁, H₂, a clock signal as shown in fig 9D is supplied from a terminal 110 to the CCDs 101, 102. That is, one clock pulse at frequency f_{c} is supplied during the first horizontal period H₁ and two clock pulses at frequency 2f_{c} are supplied during the second horizontal period H₂. Also, during two successive horizontal periods H₁, H₂, a clock signal as shown in fig 9E is supplied from a terminal 111 to the CCDs 103, 104. That is, two clock pulses at frequency 2f_{c} are supplied during the first horizontal period H₁ and one clock pulse at frequency f_{c} is supplied during the second horizontal period H₂.

The switch circuit 107 is supplied with a control signal S_{sw1} from a terminal 112 and this switch circuit 107 is switched so as to be connected to the sides of c, d, a and b, during the first half and second half of the first horizontal period H₁ and the first half and the second half of the second horizontal period H₂, respectively.

With the above described arrangement, according to the clock pulse at the frequency f_{c} during the first horizontal period H₁, the colour-difference signals R-Y and B-Y for one horizontal period are written into the CCD 101 and the first half of the CCD 102 respectively. According to the clock pulse at the frequency 2f_{c} during the first half of the succeeding second horizontal period H the colour-difference signal R-Y for one horizontal period is read out from the CCD 101, while the colour-difference signal B-Y which has been written in the first half of the CCD 102 is transferred to the second half. The colour-difference signal R-Y read out from the CCD 101 is delivered through the switch circuit 107 and the low-pass filter 108 to the output terminal 109. Then, according to the clock pulse at the frequency 2f_{c} during the second half of the second horizontal period H₂, the colour-difference signal B-Y for one horizontal period is read out from the CCD 102. This colour-difference signal B-Y is delivered through the switch circuit 107 and the low-pass filter 108 to the output terminal 109.

Then, according to the clock pulse at the frequency f_{c} during the second horizontal period H₂, the colour-difference signals R-Y and B-Y for one horizontal period are written into the CCD 103 and the first half of the CCD 104, respectively. Further, according to the clock pulse at the frequency 2f_{c} during the first half of the succeeding first horizontal period H₁, the colour-difference signal R-Y for one horizontal period is read out from the CCD 103, while the colour-difference signal B-Y which has been written in the first half of the CCD 104 is transferred to the second half. The colour-difference signal R-Y read out from the CCD 103 is delivered through the switch circuit 107 and the low-pass filter 108 to the output terminal 109. Then, according to the clock pulse at the frequency 2f_{c} during the second half of the first horizontal period H₁, the colour-difference signal B-Y for one horizontal period is read out from the CCD 104. This colour-difference signal B-Y is delivered through the switch circuit 107 and the low-pass filter 108 to the output terminal 109.

Accordingly, a signal S_{c} in which the colour-difference signals R-Y, B-Y each are compressed to a half along the time base and thereby time-division multiplexed as shown in fig 9C is obtained from the output terminal 109.

According to the present example as described above, the clock pulses are continuously supplied to the CCDs 101-104, and therefore, lattice defect noise due to the partially broken clock pulses can be prevented from occurring.

Fig 10 shows an example of a time base expanding circuit for obtaining original colour-difference signals R-Y, B-Y from the time-divisionally multiplexed signal S_{c}.

Referring to fig 10, 111 and 113 denote CCDs each thereof having a number of bits for one horizontal period (n bits). 112 and 114 denote CCDs each thereof having the number of bits for two horizontal periods (2n bits). The CCDs 111-114 are supplied with the time-division multiplexed signal S_{c} (as shown in fig 11A) from a terminal 115. Output signals of the CCDs 111 and 113 are supplied to terminals a and b of a switch circuit 116, respectively, and the output signal of the switch circuit 116 is led out to an output terminal 118 through a low-pass filter 117. Output signals of the CCDs 112 and 114 are supplied to terminals a and b of a switch circuit 119, respectively, and the output signal of the switch circuit 119 is led out to an output terminal 121 through a low-pass filter 120.

During two successive horizontal periods H₁, H₂, a clock signal as shown in fig 11D is supplied from a terminal 122 to the CCDs 111, 112. That is, two clock pulses at frequency 2f_{c} are supplied during the first horizontal period H₁ and one clock pulse at frequency f_{c} is supplied during the second horizontal period H₂. Also, during the two successive horizontal periods H₁, H₂, a clock signal as shown in fig 11E is supplied from a terminal 123 to the CCDs 113, 114. That is, one clock pulse at frequency f_{c} is supplied during the first horizontal period H₁ and two clock pulses at frequency 2f_{c} are supplied during the second horizontal period H₂.

The switch circuits 116, 119 are supplied with a control signal S_{sw2} from a terminal 124 and these switch circuits 116, 119 are switched so as to be connected to the sides of b and a during the first horizontal period Hw and the second horizontal period H₂ respectively.

With the above described arrangement, according to the clock pulse at the frequency 2f_{c} during the first half of the first horizontal period H₁, the colour-difference signal R-Y for one horizontal period is written into each of the CCD 111 and the fist half of the CCD 112. According to the clock pulse at the frequency 2f_{c} during the second half of the first horizontal period H₁, the colour-difference signal B-Y for one horizontal period is written into each of the CCD 111 and the first half of the CCD 112, while the colour-difference signal R-Y for one horizontal period which has been written in the first half of the CCD 112 is transferred to the second half. Then, according to the clock pulse at the frequency f_{c} during the succeeding second horizontal period H₂, the colour-difference signals B-Y and R-Y each for one horizontal period are read out from the CCDs 111 and 112 and delivered through the switch circuits 116 and 119 and the low-pass filters 117 and 120 to the output terminals 118 and 121 respectively.

According to the clock pulse at the frequency 2f_{c} during the first half of the second horizontal period H₂, the colour-difference signal R-Y for one horizontal period is written into each of the CCD 113 and the first half of the CCD 114. According to the clock pulse at the frequency 2f_{c} during the second half of the second horizontal period H₂, the colour-difference signal B-Y for one horizontal period is written into each of the CCD 113 and the first half of the CCD 114, while the colour-difference signal R-Y for one horizontal period which has been written in the first half of the CCD 114 is transferred to the second half. Then, according to the clock pulse at the frequency f_{c} during the succeeding first horizontal period H₁, the colour-difference signals B-Y and R-Y each for one horizontal period are read out from the CCDs 113 and 114 and delivered through the switch circuits 116 and 119 and the low-pass filters 117 and 120 to the output terminals 118 and 121, respectively.

Accordingly, the blue colour-difference signal B-Y and the red colour-difference signal R-Y, each expanded twofold along the time base as shown in figs 11B and 11C are continuously obtained at the output terminals 118 and 121.

The clock pulses are continuously supplied to the CCDs 111-114 also in the time base expanding circuit in the example of fig 10, and, therefore, lattice defect noise can be prevented from occurring.

Accordingly to the apparatus for compressing and/or expanding the time base of the present invention, as apparent from the foregoing description, a CCD therein having a charge transfer channel disposed thereon with bend portions therein is supplied with an input signal and the writing of the input signal to the CCD and the reading of the written signal from the CCD are carried out according to improved transfer clock pulse signals, whereby the input signal supplied to the CCD can be output from the output side of the CCD with its time base compressed or expanded, and further, the noise component which may be caused by the signal charge transfer operation through the bend portion in the charge transfer channel of the CCD and included in the output signal delivered to the output side of the CCD with its time base compressed or expanded can be effectively decreased.

Further, since the writing of the input signal to the CCD and reading out of the written signal from the CCD are performed according to the improved transfer clock pulse signals, a stabilised level is provided in the output signal delivered to the output side of the CCD with its time base compressed or expanded.

## Claims

1. Apparatus for compressing and/or expanding the time base of an input signal, characterised in that it comprises:
charge coupled device means (22) having an input terminal (21) which in use is supplied with said input signal, an output terminal, first and second clock terminals, and a charge transfer channel (13) through which charges corresponding to said input signal are transferred, said charge transfer channel (13) having bend portions (13A) at which the direction of the charge transfer is changed,
clock generating means (24) for generating a write clock signal (P) and a read clock signal (Q) in a time-divisional manner, the frequency of said read clock signal (Q) being different from that of said write clock signal (P), and
clock driver means (25) selectively supplied with one of said write (P) and read (Q) clock signals for generating first and second pulse trains (Pʹφ1, Pʹφ2) to be supplied to said first and second clock terminals, respectively, when said write clock signal (P) is supplied and generating third and fourth pulse trains (Qʹφ1, Qʹφ2) to be supplied to said first and second terminals, respectively, when said read clock (Q) signal is supplied, said first pulse train (Pʹφ1) being 180° out of phase with said second pulse train (Pʹφ2) and said third pulse train (Qʹφ1) being 180° out of phase with said fourth pulse train (Qʹφ2), the pulse width of said first pulse train (Pʹφ1) being substantially equal to that of said third pulse train (Qʹφ1) and being smaller than half of the shorter one of said write clock period (Tw) and read clock period (Tr).

2. Apparatus for compressing and/or expanding the time base of an input signal according to claim 1, wherein the duty cycles of said write clock signal (P) and read clock signal (Q) are 50%.

3. Apparatus for compressing and/or expanding the time base of an input signal according to claim 1 or 2, wherein said clock driver means (25) includes a D-type flip-flop (31) having a data input terminal (D) connected to a first reference voltage source (+B), first and second output terminals (Q, Q) one of which is connected to a second reference voltage source through a series circuit of a resistor (32) and a capacitor (33), said resistor (32) being shunted by a diode (34), a reset terminal (R) connected to the junction of said resistor (32) and capacitor (33), and a clock terminal (31) which, in use, is supplied with the output of said clock generating means (23).

4. Apparatus for compressing and/or expanding the time base of an input signal according to any one of the preceeding claims, wherein the frequency of said write clock signal (P) is lower than the frequency of said read clock signal (Q) whereby the time base of said input signal is compressed.

5. Apparatus for compressing and/or expanding the time base of an input signal according to claim 1, 2 or 3, wherein the frequency of said write clock signal (P) is higher than the frequency of said read clock signal (Q) whereby the time base of said input signal is expanded.

6. Apparatus according to any one of the preceding claims, for time base comprises a pair of chrominance of colour difference signals of a video signal, wherein a pair of such charge coupled devices are provided for each such signal, the devices (102, 104) associated with one of the signals having storage capacity for a time segment of the video signal twice that of the other pair of devices (101, 103), the respective signals being applied to the associated pair of devices and the outputs of the respective devices being sampled such that a single output signal containing the two chrominance or colour difference signals in time-interleaved relationship is obtained.

7. Apparatus according to claim 6, further comprising charge coupled device means adapted to de-interleave and time-base expand the signals contained in said output signals.

## Patentansprüche

1. Vorrichtung zur Kompression und/oder Dehnung einer Zeitbasis eines Eingangssignals,
***gekennzeichnet** durch*
einer ladungsgekoppelten Einrichtung (22) mit einem zum Zuführen des Eingangssignals verwendeten Eingangsanschluß (21), einem ersten und zweiten Taktanschluß und einem Ladungsübertragungskanal (13), durch welchen mit dem Eingangssignal korrespondierende Ladungen übertragen werden, wobei der Ladungsübertragungskanal (13) gebogene Bereiche (13A) aufweist, bei welchen die Richtung der Ladungsübertragung geändert wird,
einer Takterzeugungseinrichtung (24) zu einer zeitaufgeteilten Erzeugung eines Schreibtaktsignals (P) und eines Lesetaktsignals (Q), wobei die Frequenz des Lesetaktsignals (Q) von der Frequenz des Schreibtaktsignals (P) verschieden ist, und eine selektiv mit dem Schreibtaktsignal (P) und Lesetaktsignal (Q) bedienten Taktbetriebseinrichtung (25) zur Erzeugung eines dem ersten und zweiten Taktanschluß zuzuführenden ersten bzw. zweiten Impulszuges (P'φ1, P'φ2) beim Zuführen des Schreibtaktsignals (P) und Erzeugen eines dem ersten und zweiten Anschluß zuzuführenden dritten bzw. vierten Impulszuges (Q'φ1, Q'φ2) beim Zuführen des Lesetaktsignals (Q), wobei der erste Impulszug (P'φ1) gegenüber dem zweiten Impulszug (P'φ2) um 180° phasenverschoben ist, und der dritte Impulszug (Q'φ1) gegenüber dem vierten Impulszug (Q'φ2) um 180° phasenverschoben ist, und wobei die Impulsbreite des ersten Impulszuges (P'φ1) im wesentlichen gleich der Impulsbreite des dritten Impulszuges (Q'φ1) und kleiner als die Hälfte der kürzeren von zwei Taktperioden, einer Schreibtaktperiode (Tw) und einer Lesetaktperiode (Tr), ist.

2. Vorrichtung nach Anspruch 1,
dadurch **gekennzeichnet,** daß
das Taktverhältnis des Schreibtaktsignals (P) und des Lesetaktsignals (Q) 50% beträgt.

3. Vorrichtung nach Anspruch 1 oder 2,
dadurch **gekennzeichnet,** daß
die Taktbetriebseinrichtung (25) ein D-Flip-Flop (31) mit einem an eine erste Bezugsspannungquelle (+B) angeschlossenen Dateneingangsanschluß (D), einem ersten und zweiten Ausgangsanschluß (Q, Q̅), deren einer durch eine Serienschaltung aus einem durch eine Diode (34) nebengeschlossenen Widerstand (32) und einem Kondensator (33) an eine zweite Bezugsspannungsquelle angeschlossen ist, einem an die Verbindung des Widerstandes (32) und des Kondensators (33) angeschlossenen Rücksetzanschluß (R) und einem Taktanschluß (31), dem bei Benutzung das Ausgangssignal der Takterzeugungseinrichtung (24) zugeleitet ist.

4. Vorrichtung nach einem der vorhergehenden Ansprüche,
dadurch **gekennzeichnet,** daß
die Frequenz des Schreibtaktsignals (P) niedriger als die Frequenz des Lesetaktsignals (Q) ist, wodurch die Zeitbasis des Eingangssignals komprimiert wird.

5. Vorrichtung nach Anspruch 1, 2 oder 3,
dadurch **gekennzeichnet,** daß
die Frequenz des Schreibtaktsignals (P) höher als die Frequenz des Lesetaktsignals (Q) ist, wodurch die Zeitbasis des Eingangssignals gedehnt wird.

6. Vorrichtung nach einem der vorhergehenden Ansprüche,
dadurch **gekennzeichnet,** daß
die Zeitbasis ein Paar Chrominanz- oder Farbdifferenzsignale eines Videosignals aufweist, wobei für jedes dieser Signale je ein Paar ladungsgekoppelter Vorrichtungen (102, 104; 101, 103) vorgesehen ist, wobei das einem dieser Signale zugordnete Paar ladungsgekoppelter Einrichtungen (102, 104) eine Speicherkapazität für ein Zeitsegment des Videosignals aufweisen, die zwei Mal so groß ist, wie jene des anderen Paares ladungsgekoppelter Einrichtungen (101, 103), wobei die jeweiligen Signale den zugeordneten Paaren ladungsgekoppelter Einrichtungen zugeleitet sind und die Ausgangssignale der jeweiligen ladungsgekoppelten Einrichtungen derart abgetastet sind, daß ein die Chrominanz- oder Farbdifferenzsignale enthaltendes einzelnes Ausgangssignal zeitverschachtelt erhalten ist.

7. Vorrichtung nach Anspruch 6,
***gekennzeichnet** durch*
durch eine ladungsgekoppelte Einrichtung zur Entschachtelung und Zeitbasisdehnung der in den Ausgangssignalen enthaltenen Signale.

## Revendications

1. Dispositif de compression et/ou d'expansion de la base de temps d'un signal d'entrée, caractérisé en ce qu'il comprend:
un moyen formant un dispositif à couplage de charge (22), possédant une borne d'entrée (21) à laquelle est appliqué le signal d'entrée pendant l'utilisation, une borne de sortie, une première et une seconde borne d'horloge et un canal de transfert de charge (13) à travers duquel sont transférées des charges correspondant au signal d'entrée, le canal de transfert de charge (13) comportant des parties courbes (13a) auxquelles la direction de transfert de charge est changée,
un moyen générateur d'horloge (24) pour générer un signal d'horloge d'écriture (P) et un signal d'horloge d'écriture (Q) de façon répartie dans le temps, la fréquence du signal d'horloge de lecture (Q) étant différente de celle du signal d'horloge d'écriture (P), et
un moyen d'attaque d'horloge (25) auquel est fourni sélectivement l'un des signaux d'horloge d'écriture (P) et de lecture (Q) et qui est destiné à générer un premier et un second train d'impulsions (P'φ1, P'φ2) à appliquer respectivement à la première et à la seconde borne d'horloge lorsque le signal d'horloge d'écriture (P) est fourni, et à générer un troisième et un quatrième train d'impulsions (Q'φ1, Q'φ2) à appliquer respectivement à la première et à la seconde borne d'horloge lorsque le signal d'horloge de lecture (Q) est fourni, le premier train d'impulsions (P'φ1) étant déphasé de 180° par rapport au second train d'impulsions (P'φ2) et le troisième train d'impulsions (Q'φ1) étant déphasé de 180° par rapport au quatrième train d'impulsions (Q'φ2), la largeur d'impulsion du premier train d'impulsions (P'φ1) étant sensiblement égale à celle du troisième train d'impulsions (Q'φ1) et plus petite que la moitié de la plus courte des deux périodes que sont la période d'horloge d'écriture (Tw) et la période d'horloge de lecture (Tr).

2. Dispositif de compression et/ou d'expansion de la base de temps d'un signal d'entrée selon la revendication 1, dans lequel les rapports cycliques du signal d'horloge d'écriture (P) et du signal d'horloge de lecture (Q) sont de 50%.

3. Dispositif de compression et/ou d'expansion de la base de temps d'un signal d'entrée selon la revendication 1 ou 2, dans lequel le moyen d'attaque d'horloge (25) comporte une bascule de type D (31) possédant une borne d'entrée de données (D) connectée à une première source de tension de référence (+B), une première et une seconde borne de sortie (Q, Q̅) dont l'une est connectée à une seconde source de tension de référence à travers un montage en série d'une résistance (32) et d'un condensateur, la résistance (32) étant shuntée par une diode (34), une borne de remise à l'état initial (R) connectée à la jonction de la résistance (32) et du condensateur (33) et une borne d'horloge (35) à laquelle est appliqué, pendant l'utilisation, le signal de sortie du moyen générateur d'horloge (23).

4. Dispositif de compression et/ou d'expansion de la base de temps d'un signal d'entrée selon l'une quelconque des revendication précédentes, dans lequel la fréquence du signal d'horloge d'écriture (P) est inférieure à la fréquence du signal d'horloge de lecture (Q), de sorte que la base de temps du signal d'entrée est comprimée.

5. Dispositif de compression et/ou d'expansion de la base de temps d'un signal d'entrée selon la revendication 1, 2 ou 3, dans lequel la fréquence du signal d'horloge d'écriture (P) est supérieure à la fréquence du signal d'horloge de lecture (Q), de sorte que la base de temps du signal d'entrée est expansée.

6. Dispositif selon l'une quelconque des revendications précédentes pour la compression de la base de temps d'une paire de signaux de chrominance ou de différence de couleur d'un signal vidéo, dans lequel une paire de tels dispositifs à couplage de charge est prévue pour chacun de ces signaux, les dispositifs à couplage de charge (102, 104) coordonnés à l'un des signaux ayant une capacité de stockage pour un segment temporel du signal vidéo correspondant au double de la capacité de stockage de l'autre paire de dispositifs à couplage de charge (101, 103), les signaux respectifs étant appliqués à la paire coordonnée de dispositifs et les signaux de sortie des dispositifs respectifs étant échantillonés, de manière qu'on obtienne un seul signal de sortie contenant les deux signaux de chrominance ou de différence de couleur dans une relation à intercalation temporelle.

7. Dispositif selon la revendication 6, possédant en outre un moyen formant un dispositif à couplage de charge conçu pour supprimer l'intercalation temporelle et pour l'expansion de la base de temps des signaux contenus dans le signal de sortie.
